# EUROPEAN PATENT APPLICATION

(11) **EP 4 202 983 A1**
(43) Date of publication of application: **28.06.2023**
(21) Application number: 22214435.4
(22) Date of filing: 19.12.2022
(51) Int. Cl.: H01L 21/67, C23C 16/44, C23C 16/458, C23C 16/46, H01L 21/673

(54) **HIGH PRESSURE HEAT TREATMENT APPARATUS**

(30) Priority: 27.12.2021 KR 20210188405
(71) Applicant: HPSP Co., Ltd., Suwon-si, Gyeonggi-do (KR)
(72) Inventor: LIM, Kun Young, (101-dong, 1301-ho) 43, Wongol-ro,Uiwang-si, Gyeonggi-do (KR)
(74) Representative: von Bülow & Tamada

(57) **Abstract**

Provided is a high pressure heat treatment apparatus including: an internal chamber accommodating an object to be heat-treated; an external chamber including a high-temperature zone accommodating the internal chamber and a low-temperature zone having a lower temperature than the high-temperature zone; a gas supply module including a process gas line for supplying a process gas for the heat treatment to the internal chamber at a first pressure higher than that of the atmosphere and a protective gas line for supplying a protective gas to the external chamber at a second pressure set in relation to the first pressure; a switch module configured to switch the high-temperature zone and the low-temperature zone into a communication state; and a purge module configured to purge the protective gas in the high-temperature zone to the low-temperature zone in the communication state.

## Description

### BACKGROUND

### Field

The present disclosure relates to a heat treatment apparatus used to heat-treat an object in a high-pressure environment.

### Description of the Related Art

In general, an ion implantation process during semiconductor fabrication may cause damage to an interface of a wafer. Annealing may be a process of healing the damage to the corresponding wafer through heat treatment. In addition to the annealing, the heat treatment may also be performed on the wafer when activating impurities, when performing a chemical vapor deposition (CVD) process to form a thin film, and when performing an ohmic contact alloy process.

During the heat treatment, a gas may act on the wafer. The gas may be supplied at a high pressure to a chamber in which the wafer is accommodated. After the heat treatment is finished, the used gas may be exhausted from the chamber. After the gas is exhausted, the heat-treated wafer may be withdrawn from the chamber. A new wafer and the gas may then be provided to the chamber for the next heat treatment.

The chamber may have a sealing ability of a predetermined level or higher to prevent the gas from leaking to the outside. The sealing ability (and insulation property) of the chamber may also be important to prevent heat in the chamber from leaking to the outside. However, this sealing ability may act as an obstacle to lowering a temperature of the chamber.

In detail, the heat treatment may be performed at a high temperature, and it is thus necessary to lower the temperature of the chamber during or after the heat treatment. For example, the temperature of the chamber is first required to be lower to withdraw the heat-treated wafer after the heat treatment is finished. However, a long time needs to cool the chamber due to the sealing ability of the chamber. As a result, a tact time in a heat treatment process for the wafers may become longer.

### SUMMARY

An object of the present disclosure is to provide a high pressure heat treatment apparatus in which a high-temperature chamber can be rapidly cooled.

According to an embodiment of the present disclosure, a high pressure heat treatment apparatus includes: an internal chamber accommodating an object to be heat-treated; an external chamber including a high-temperature zone accommodating the internal chamber and a low-temperature zone having a lower temperature than the high-temperature zone; a gas supply module including a process gas line for supplying a process gas for the heat treatment to the internal chamber at a first pressure higher than that of the atmosphere and a protective gas line for supplying a protective gas to the external chamber at a second pressure set in relation to the first pressure; a switch module configured to switch the high-temperature zone and the low-temperature zone into a communication state; and a purge module configured to purge the protective gas in the high-temperature zone to the low-temperature zone in the communication state.

The purge module may include a ring body surrounding the internal chamber, and a discharge channel positioned in the ring body and discharging an input purge gas to the internal chamber.

The discharge channel may include a loop line extending in a circumferential direction of the ring body, and a plurality of branch lines connected to the loop line and arranged to direct the internal chamber.

The apparatus may further include a heating module disposed in the high-temperature zone and configured to heat the process gas and the protective gas in the high-temperature zone, wherein the discharge channel discharges the purge gas into a space between the internal chamber and the heating module.

The heating module may include a heater disposed to direct the internal chamber, and a heat insulation block mounted on an inner surface of the external chamber and blocking heat generated by the heater from being transferred to the outside of the external chamber, and the discharge channel may discharge the purge gas to flow to the heat insulation block.

The gas supply module may further include a purge gas line for inputting the purge gas to the discharge channel.

The external chamber may further include a housing having an inner space, and a partition plate partitioning the inner space into the high-temperature zone and the low-temperature zone, the housing may further include a cover part defining the low-temperature zone together with the partition plate, and at least one of the cover part and the partition plate may accommodate a cooling medium for cooling the protective gas purged into the low-temperature zone.

The partition plate may include a discharge hole opened to allow the high-temperature zone and the low-temperature zone to communicate with each other, and the switch module may include a hole cover positioned to correspond to the discharge hole, and a driving unit configured to move the hole cover between a closing position for closing the discharge hole and an opening position for opening the discharge hole.

The external chamber may enable the protective gas to circulate to the high-temperature zone after being cooled in the low-temperature zone by exchanging heat with the cooling medium.

The apparatus may further include a gas exhaust module configured to exhaust the process gas and the protective gas from the internal chamber and the external chamber, wherein the gas exhaust module exhausts the protective gas to maintain the second pressure when the purge module is operated.

According to another embodiment of the present disclosure, a high pressure heat treatment apparatus includes: an internal chamber accommodating an object to be heat-treated; an external chamber accommodating the internal chamber; a gas supply module including a process gas line for supplying a process gas for the heat treatment to the internal chamber at a first pressure higher than that of the atmosphere and a protective gas line for supplying a protective gas to the external chamber at a second pressure set in relation to the first pressure; and a purge module configured to purge the protective gas by injecting a purge gas into the external chamber, wherein the purge module includes a ring body surrounding the internal chamber, and a discharge channel positioned in the ring body, and discharging the input purge gas to the internal chamber.

The discharge channel may include a loop line extending in a circumferential direction of the ring body, and a plurality of branch lines connected to the loop line and arranged to direct the internal chamber.

The apparatus may further include a heating module disposed in the external chamber and configured to heat the process gas and the protective gas, wherein the discharge channel discharges the purge gas into a space between the internal chamber and the heating module.

The gas supply module may further include a purge gas line connected to the protective gas line and supplying the purge gas to the discharge channel.

The apparatus may further include a gas exhaust module configured to exhaust the process gas and the protective gas from the internal chamber and the external chamber, wherein the gas exhaust module exhausts the protective gas to maintain the second pressure when the purge gas is injected.

### BRIEF DESCRIPTION OF THE DRAWINGS

FIG. 1 is a conceptual diagram of a high pressure heat treatment apparatus 100 according to an embodiment of the present disclosure.
FIG. 2 is a block diagram for explaining a control configuration of the high pressure heat treatment apparatus 100 of FIG. 1.
FIG. 3 is a partial cross-sectional view showing a state of components related to a switch module 150 and a purge module 160 included in the high pressure heat treatment apparatus 100 of FIG. 1.
FIG. 4 is a partial cross-sectional view showing another state of the components related to the switch module 150 and the purge module 160 of FIG. 3.
FIG. 5 is a plan view of a partition plate 123 of FIG. 4.
FIG. 6 is a conceptual diagram showing one state of the switch module 150 of FIG. 3.
FIG. 7 is a conceptual diagram showing another state of the switch module 150 of FIG. 3.
FIG. 8 is a plan view showing the purge module 160 of FIG. 3.

### DETAILED DESCRIPTION

Hereinafter, a high pressure heat treatment apparatus according to embodiments of the present disclosure are described in detail with reference to the accompanying drawings. Throughout the present disclosure, components that are the same as or similar to each other are denoted by reference numerals that are the same as or similar to each other, and a description thereof is replaced by the first description, even in a different embodiment.

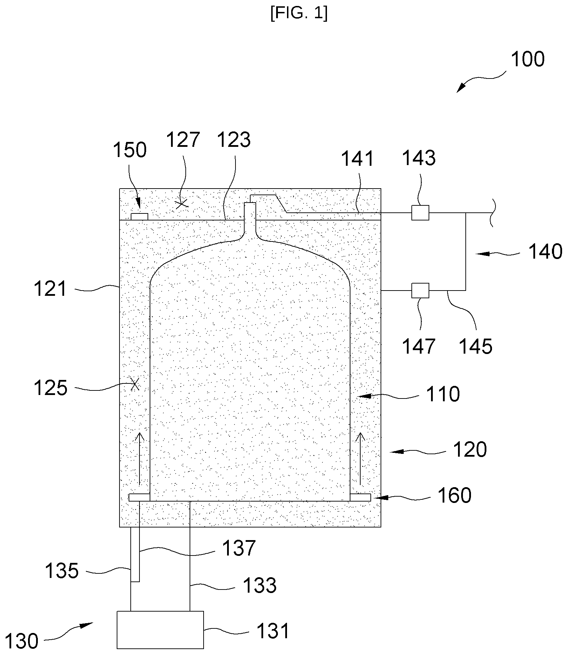

FIG. 1 is a conceptual diagram of a high pressure heat treatment apparatus 100 according to an embodiment of the present disclosure.

Referring to this drawing, the high pressure heat treatment apparatus 100 may include an internal chamber 110, an external chamber 120, a gas supply module 130, a gas exhaust module 140, a switch module 150, and a purge module 160.

The internal chamber 110 may have an accommodation space accommodating an object to be heat-treated. The internal chamber 110 may be made of a non-metallic material, for example, quartz, to reduce a possibility that contaminants (particles) are present in a high-pressure and high-temperature process environment. Although simplified in the drawing, a door (not shown) for opening the accommodation space may be positioned at a lower end of the internal chamber 110. The accommodation space may be opened as the door descends, and the object may be put into the internal chamber 110 while being mounted on a holder (not shown). As a heater (not shown) disposed outside the internal chamber 110 is operated, the internal chamber 110 may be heated up to several hundred degrees Celsius. The object may be, for example, a semiconductor wafer. In this case, the holder may be a wafer boat which may stack the semiconductor wafers in a plurality of layers.

The external chamber 120 may be configured to accommodate the internal chamber 110. Unlike the internal chamber 110, the external chamber 120 is free from a problem of contamination of the semiconductor wafer, and may thus be made of a metal material. The external chamber 120 may include a housing 121 having an inner space accommodating the internal chamber 110. The housing 121 may also have a door (not shown) at a lower portion. The door may open the inner space while descending together with the door of the internal chamber 110.

The inner space may be partitioned into two zones by a partition plate 123. A zone positioned lower than the partition plate 123 may be a high-temperature zone 125 where the internal chamber 110 is positioned. The other zone positioned higher than the partition plate 123 may be a low-temperature zone 127 having a lower temperature than the high-temperature zone 125. The high-temperature zone 125 may have a temperature close to that of the internal chamber 110 due to heating of the heater, and the low-temperature zone 127 may have a much lower temperature than the high-temperature zone 125. The low-temperature zone 127 may be affected by a cooling medium, for example, cooling water.

The gas supply module 130 may be configured to supply a gas to the chambers 110 and 120. The gas supply module 130 may have a gas supplier 131 communicating with a utility (or a gas supply facility) of a semiconductor factory. The gas supplier 131 may selectively supply the internal chamber 110 with a process gas such as hydrogen/deuterium, fluorine, ammonia, chlorine, nitrogen. The gas supplier 131 may provide the external chamber 120 with a protective gas such as nitrogen which is an inert gas. The protective gas injected into the external chamber 120 may specifically fill a space between the external chamber 120 and the internal chamber 110. The process gas and the protective gas may each be injected into the internal chamber 110 or the external chamber 120 through a process gas line 133 or a protective gas line 135. The gas supplier 131 may also provide the external chamber 120 with a purge gas. The purge gas may be injected into the external chamber 120, specifically, the space between the external chamber 120 and the inner chamber 110 to purge the protective gas. The purge gas may be, for example, nitrogen, which is an inert gas. The purge gas may be injected into the external chamber 120 through a purge gas line 137 branched from the protective gas line 135.

The process gas and the protective gas may be at pressures higher than that of the atmosphere, and supplied to form, for example, high pressures ranging from several to several tens of atmospheres. In addition, when a first pressure indicates the pressure of the process gas and a second pressure indicates the pressure of the protective gas, these pressures may maintain a predetermined relationship. For example, the second pressure may be set to be slightly higher than the first pressure. Such a pressure difference may prevent the process gas from leaking from the internal chamber 110. The protective gas may be partially exhausted while the purge gas is supplied, and the second pressure may thus be maintained.

The gas exhaust module 140 may be configured to exhaust the process gas and the protective gas from the chambers 110 and 120. A gas exhaust pipe 141 may be connected to the top of the internal chamber 110 to exhaust the process gas from the internal chamber 110. The gas exhaust pipe 141 may be disposed in the low-temperature zone 127, and extend out of the external chamber 120 from the low-temperature zone 127. A gas discharger 143 may be installed in the gas exhaust pipe 141. The gas discharger 143 may be a valve that controls the exhaust of the process gas.

Similarly, a gas exhaust pipe 145 communicating with the external chamber 120 and a gas discharger 147 installed therein may be provided to discharge the protective gas from the external chamber 120. These gas exhaust pipes 141 and 145 may communicate with each other, and the process gas may thus be diluted with the protective gas and then exhausted while having a lower concentration.

The switch module 150 may be configured to switch the high-temperature zone 125 and the low-temperature zone 127 into a communication state. The switch module 150 may be operated to switch a state of the partition plate 123 to the communication state. When the communication state is established, the protective gas in the high-temperature zone 125 may flow to the low temperature zone 127.

The purge module 160 may be configured to purge the protective gas in the high-temperature zone 125 to the low-temperature zone 127. The purge module 160 may surround the internal chamber 110. The purge module 160 may also have a height corresponding to that of a lower portion of the internal chamber 110. The purge module 160 may discharge the purge gas to the external chamber 120, specifically, the high-temperature zone 125. Due to a pressure of the purge gas, the protective gas in the high-temperature zone 125 may be forced to flow into the low-temperature zone 127. This operation is possible because the high-temperature zone 125 and the low temperature zone 127 are in the communication state by the switch module 150. The protective gas existing in the high-temperature zone 125 may move to the low-temperature zone 127, lose thermal energy, and return to the high-temperature zone 125 again. The high-temperature zone 125 and the internal chamber 110 (as well as the semiconductor wafer) can be rapidly cooled by the forced circulation and heat exchange of the protective gas.

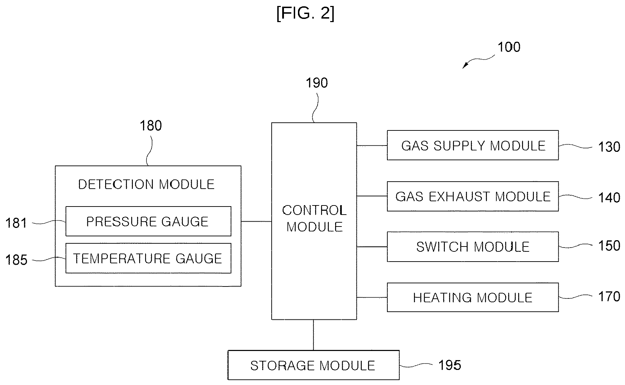

The description describes a control configuration of the high pressure heat treatment apparatus 100 with reference to FIG. 2. FIG. 2 is a block diagram for explaining the control configuration of the high pressure heat treatment apparatus 100 of FIG. 1.

Referring to this drawing (and FIG. 1), the high pressure heat treatment apparatus 100 may further include a heating module 170, a detection module 180, a control module 190, and a storage module 195 in addition to the gas supply module 130 or the like, described above.

The heating module 170 may include the above-mentioned heater. The heater may be disposed in the inner space of the external chamber 120. The heater may heat the process gas to a process temperature.

The detection module 180 may be configured to detect environments of the chambers 110 and 120. The detection module 180 may include a pressure gauge 181 and a temperature gauge 185. A pressure gauge 181 and a temperature gauge 185 may be installed in each of the chambers 110 and 120.

The control module 190 may be configured to control the gas supply module 130, the gas exhaust module 140, or the like. The control module 190 may control the gas supply module 130 or the like based on a detection result of the detection module 180.

The storage module 195 may be configured to store data, programs, or the like that the control module 190 may refer to for the control. The storage module 195 may include at least one type of storage medium among a flash memory, a hard disk, a magnetic disk, and an optical disk.

Through this configuration, the control module 190 may control an operation of the gas supply module 130 based on the pressures of the chambers 110 and 120 that are obtained through the pressure gauge 181. The process gas and the protective gas may be supplied to the chambers 110 and 120, and the chambers 110 and 120 may respectively reach the first pressure and the second pressure.

The control module 190 may also control operations of the switch module 150 and the gas supply module 130 based on the temperatures of the chambers 110 and 120 that are obtained through the temperature gauge 185. The operations of the switch module 150, the gas supply module 130, and the purge module 160 may be performed when the temperatures of the chambers 110 and 120 need to be lower during the heat treatment or when the heat treatment is finished.

The process gas may be cooled to a predetermined temperature or less by the forced circulation and heat exchange of the protective gas based on the operations of the switch module 150, the gas supply module 130, and the purge module 160. The control module 190 may operate the gas exhaust module 140 to exhaust the cooled process gas. Therefore, it is possible to preemptively remove a risk factor such as an explosion which may occur as the process gas is exhausted while having a high temperature.

The control module 190 may control the gas exhaust module 140 to partially exhaust the protective gas while the purge gas is injected into the external chamber 120. Accordingly, the second pressure may be maintained even when the purge gas is injected.

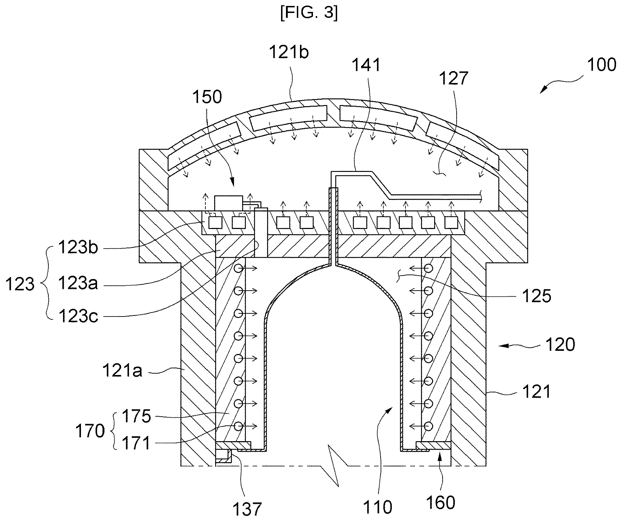

The description describes the specific configurations and operations of the switch module 150 and the purge module 160 with reference to FIGS. 3 to 8.

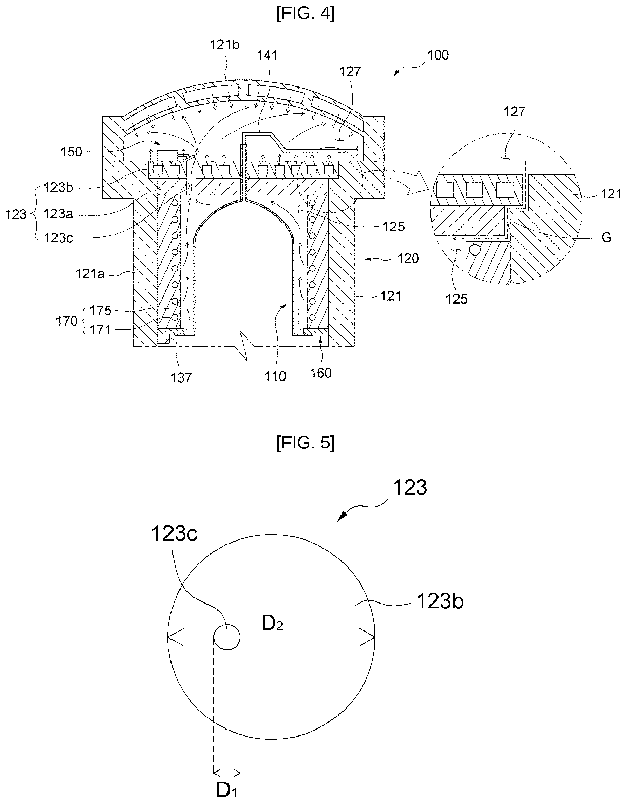

First, FIG. 3 is a partial cross-sectional view showing a state of components related to the switch module 150 and the purge module 160 included in the high pressure heat treatment apparatus 100 of FIG. 1; and FIG. 4 is a partial cross-sectional view showing another state of the components related to the switch module 150 and the purge module 160 of FIG. 3. These drawings omit illustrations of the doors, semiconductor wafers, or the like of the chambers 110 and 120 to avoid complexity of the drawings.

Referring further to these drawings, the housing 121 may include a body part 121a and a cover part 121b. The body part 121a may have a substantially cylindrical shape, and the cover part 121b may have a shape corresponding to an open top of the body part 121a. The cover part 121b may have a substantially dome shape.

The partition plate 123 may be spaced apart from the cover part 121b while facing the cover part 121b. The partition plate 123 may be disposed below the cover part 121b while being supported by the body part 121a. The partition plate 123 may define the high-temperature zone 125 together with the body part 121a and define the low-temperature zone 127 together with the cover part 121b.

The heating module 170 may be disposed in the high-temperature zone 125. The heating module 170 may include a heater 171 and a heat insulation block 175. The heater 171 may be disposed to direct the internal chamber 110. The heat generated by the heater 171 may heat the protective gas in the high-temperature zone 125 and the process gas in the internal chamber 110. The heat insulation block 175 may be mounted on an inner surface of the body part 121a. The heat insulation block 175 may block the heat generated by the heater 171 from being transferred to the body part 121a. The heater 171 may be a heating wire surrounding the internal chamber 110 and embedded in the heat insulation block 175.

A heat insulation layer 123a may occupy a lower portion of the partition plate 123 to correspond to the heater 171. The heat insulation layer 123a may be disposed above the heating module 170 and face the heater 171. The heat insulation layer 123a may block the heat generated by the heater 171 from being transferred to the low-temperature zone 127.

A cooling layer 123b may occupy an upper portion of the partition plate 123. The cooling layer 123b may have a space accommodating the cooling medium, for example, the cooling water. A space accommodating the cooling water may also be positioned in the cover part 121b to correspond to the cooling layer 123b. The cover part 121b may accommodate a greater amount of cooling water than the partition plate 123. The cover part 121b may define an upper portion of the low-temperature zone 127, and the protective gas discharged to the low-temperature zone 127 may thus mainly exchange the heat with the cover part 121b as the gas rises to the maximum.

The cooling water accommodated in the cover part 121b and/or the cooling layer 123b may fill the low-temperature zone 127 with cold air. Accordingly, the low-temperature zone 127 may maintain a low temperature. The protective gas discharged to the low-temperature zone 127 may be cooled by exchanging the heat with the cold air.

A discharge hole 123c may pass through the partition plate 123. The discharge hole 123c may allow the high-temperature zone 125 and the low-temperature zone 127 to communicate with each other. The discharge hole 123c may be positioned to correspond to a space between the internal chamber 110 and the heating module 170. The discharge hole 123c may be opened and closed by the switch module 150.

The external chamber 120 may enable the protective gas to circulate from the low-temperature zone 127 to the high-temperature zone 125. For example, the external chamber 120 may have a gap G between the partition plate 123 and the body part 121a, or between the body part 121a and the heating module 170. In this case, the protective gas may circulate through the gap G.

The purge module 160 may discharge the purge gas into the space between the internal chamber 110 and the heating module 170. The purge gas may be reflected from the internal chamber 110 and flow to the heat insulation block 175. The purge gas may be discharged at a room temperature, thus cooling the heat accumulated in the internal chamber 110 and the heat insulation block 175.

Through this configuration, the heat generated by the heater 171 may heat the gas in the internal chamber 110 and the high-temperature zone 125 in a state where the switch module 150 closes the discharge hole 123c (see FIG. 3). The heat generated by the heater 171 may be prevented from being easily transferred to the low-temperature zone 127 due to the heat insulation layer 123a. The low-temperature zone 127 may maintain the low temperature also by the cooling water of the cover part 121b and/or the cooling layer 123b. Accordingly, the high-temperature zone 125 and the low-temperature zone 127 may have temperatures greatly different from each other even though the two zones have the same pressure as each other.

When the process gas needs to be cooled, the discharge hole 123c may be opened by the operation of the switch module 150. The purge gas discharged through the purge gas line 137 and the purge module 160 may forcibly convect the protective gas in the high-temperature zone 125. The protective gas may flow into the low-temperature zone 127 through the discharge hole 123c. The high-temperature protective gas may be cooled by exchanging the heat with the cold air of the cooling water in the low-temperature zone 127. The cooled low-temperature protective gas may return to the high-temperature zone 125 through the gap G (or the discharge hole 123c) between the partition plate 123 and the body part 121a.

As the protective gas circulates by the forced convection, the process gas may be rapidly cooled by exchanging the heat with the protective gas. After sufficiently cooled, the process gas may be exhausted to the outside through the gas exhaust pipe 141.

Next, FIG. 5 is a plan view of the partition plate 123 of FIG. 4.

Referring to this drawing, the discharge hole 123c may be positioned away from the center of the cooling layer 123b. The discharge hole 123c may be positioned to correspond to the space between the internal chamber 110 and the heating module 170 (see FIG. 3).

The cooling layer 123b may have a disk shape, and the discharge hole 123c may also be open in a circular shape. In this case, a diameter D1 of the discharge hole 123c may have a specific ratio compared to a diameter D2 of the cooling layer 123b. In detail, the ratio may be determined to a level that the thermal shock is prevented from being applied to the internal chamber 110 due to rapid heat discharge while the protective gas is discharged from the high-temperature zone 125 to the low-temperature zone 127.

The description above exemplifies the discharge hole 123c as a passage through which the protective gas flows when being discharged from the high-temperature zone 125 to the low-temperature zone 127. However, the passage may be another type. For example, as the partition plate 123 is configured to rotate or ascend with respect to a horizontal axis, a space between the partition plate 123 and the housing 121 may serve as the passage. Here, the rotation/ascent of the partition plate 123 may be performed by the operation of the switch module 150.

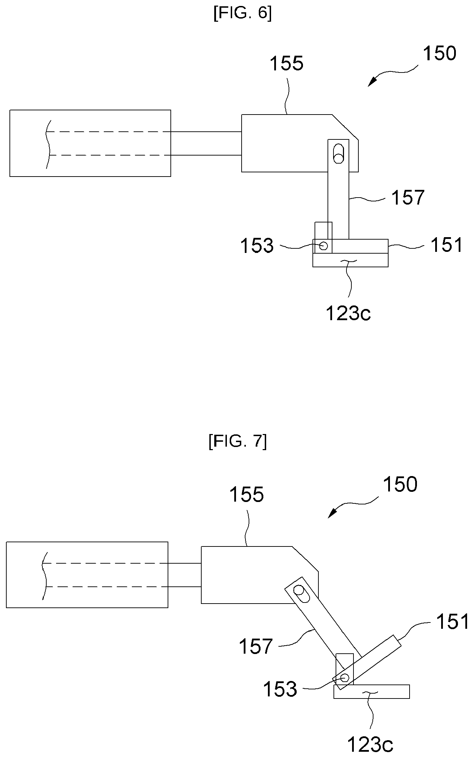

FIG. 6 is a conceptual diagram showing one state of the switch module 150 of FIG. 3; and FIG. 7 is a conceptual diagram showing another state of the switch module 150 of FIG. 3.

Referring further to these drawings, the switch module 150 may include a hole cover 151, a hinge 153, an actuator 155, and a link 157.

The hole cover 151 may have a size corresponding to that of the discharge hole 123c. The hole cover 151 may close the discharge hole 123c in a closing position (see FIG. 6). The hole cover 151 may open the discharge hole 123c in an opening position (see FIG. 7).

The hole cover 151 may be rotatably coupled to the partition plate 123 by the hinge 153. This configuration may allow the hole cover 151 to rotate between the closing position and the opening position.

The switch module 150 may include a driving unit configured to move the hole cover 151. The driving unit may include the actuator 155 and the link 157.

The actuator 155 may be configured to move forward and backward. The actuator 155 may be, for example, a cylinder operated forward and backward. In more detail, the cylinder may be an electric cylinder operated by an electric motor.

The link 157 may be configured to connect a moving portion of the cylinder to the hole cover 151. One end of the link 157 may be coupled to the hole cover 151. The other end of the link 157 may be rotatably coupled to the moving portion. A long hole may be positioned in any one of the link 157 and the moving portion to correspond to the rotation of the link 157, and a pin movably inserted into the long hole may be installed on the other one.

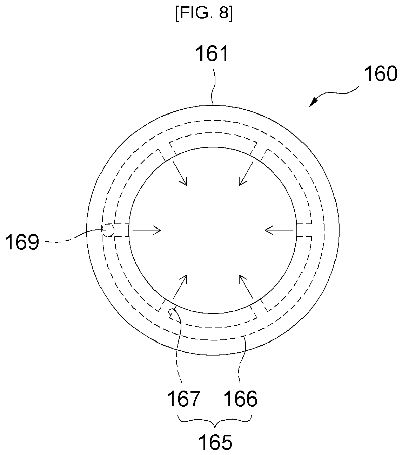

The specific configuration of the purge module 160 is described with reference to FIG. 8. FIG. 8 is a plan view showing the purge module 160 of FIG. 3.

Referring to this drawing, the purge module 160 may include a ring body 161 and a discharge channel 165.

The ring body 161 may have a substantially donut shape. The ring body 161 may surround the internal chamber 110, and its hollow portion may thus have a size enabling the internal chamber 110 to be inserted into the ring body. The ring body 161 may be formed by stacking two ring-shaped plates to process the discharge channel 165.

The discharge channel 165 may be positioned in the ring body 161, and provide a path through which the purge gas is discharged to the internal chamber 110. The discharge channel 165 may include a loop line 166 and a branch line 167.

The loop line 166 may extend in a circumferential direction of the ring body 161. The loop line 166 may form a circular path, for example. The branch line 167 may be connected to the loop line 166, and disposed to direct the internal chamber 110. The plurality of branch lines 167 may be arranged at regular intervals.

The purge gas may be input to the loop line 166 through an input terminal 169. To this end, the input end 169 may be connected with the purge gas line 137. The input end 169 may be positioned on a lower surface of the ring body 161.

The high pressure heat treatment apparatus as described above is not limited to the configurations and operation methods of the embodiments described above. The above embodiments may be variously modified by selective combinations of all or some of the respective embodiments.

For example, the purge module 160 may be used in the external chamber 120 that does not include the switch module 150 or the low-temperature zone 127. In this case, the purge module 160 may supply the purge gas to a space between the internal chamber 110 and the heat insulation block 175 to purge the high-temperature protective gas. The protective gas may be purged to thus be exhausted by the gas exhaust module 140.

According to the high pressure heat treatment apparatus according to the present disclosure configured as above, the purge gas discharged, by the purge module, to the external chamber partitioned into the high-temperature zone accommodating the internal chamber and the low-temperature zone having the lower temperature may purge the protective gas in the high-temperature zone to the low-temperature zone through the passage formed by the switch module. Accordingly, the protective gas heated in the high-temperature zone may move to the low-temperature zone by the forced convection to thus be cooled by the heat exchange.

The cooled protective gas can also rapidly circulate to the high-temperature zone by the forced convection, thus rapidly cooling the high-temperature zone and the internal chamber. In this way, it is possible to remarkably reduce the tack time in the heat treatment process for the semiconductor wafers.

## Claims

1. A high pressure heat treatment apparatus, the apparatus comprising:
an internal chamber accommodating an object to be heat-treated;
an external chamber including a high-temperature zone accommodating the internal chamber and a low-temperature zone having a lower temperature than the high-temperature zone;
a gas supply module including a process gas line for supplying a process gas for the heat treatment to the internal chamber at a first pressure higher than that of the atmosphere and a protective gas line for supplying a protective gas to the external chamber at a second pressure set in relation to the first pressure;
a switch module configured to switch the high-temperature zone and the low-temperature zone into a communication state; and
a purge module configured to purge the protective gas in the high-temperature zone to the low-temperature zone in the communication state.

2. The apparatus of claim 1, wherein the purge module includes
a ring body surrounding the internal chamber, and
a discharge channel positioned in the ring body and discharging an input purge gas to the internal chamber.

3. The apparatus of claim 2, wherein the discharge channel includes
a loop line extending in a circumferential direction of the ring body, and
a plurality of branch lines connected to the loop line and arranged to direct the internal chamber.

4. The apparatus of claim 2, further comprising a heating module disposed in the high-temperature zone and configured to heat the process gas and the protective gas in the high-temperature zone,
wherein the discharge channel discharges the purge gas into a space between the internal chamber and the heating module.

5. The apparatus of claim 4, wherein the heating module includes
a heater disposed to direct the internal chamber, and
a heat insulation block mounted on an inner surface of the external chamber and blocking heat generated by the heater from being transferred to the outside of the external chamber, and
the discharge channel discharges the purge gas to flow to the heat insulation block.

6. The apparatus of claim 2, wherein the gas supply module further includes a purge gas line for inputting the purge gas to the discharge channel.

7. The apparatus of claim 1, wherein the external chamber further includes
a housing having an inner space, and
a partition plate partitioning the inner space into the high-temperature zone and the low-temperature zone,
the housing further includes a cover part defining the low-temperature zone together with the partition plate, and
at least one of the cover part and the partition plate accommodates a cooling medium for cooling the protective gas purged into the low-temperature zone.

8. The apparatus of claim 7, wherein the partition plate includes a discharge hole opened to allow the high-temperature zone and the low-temperature zone to communicate with each other, and
the switch module includes
a hole cover positioned to correspond to the discharge hole, and
a driving unit configured to move the hole cover between a closing position for closing the discharge hole and an opening position for opening the discharge hole.

9. The apparatus of claim 7, wherein the external chamber enables the protective gas to circulate to the high-temperature zone after being cooled in the low-temperature zone by exchanging heat with the cooling medium.

10. The apparatus of claim 1, further comprising a gas exhaust module configured to exhaust the process gas and the protective gas from the internal chamber and the external chamber,
wherein the gas exhaust module exhausts the protective gas to maintain the second pressure when the purge module is operated.

11. A high pressure heat treatment apparatus, the apparatus comprising:
an internal chamber accommodating an object to be heat-treated;
an external chamber accommodating the internal chamber;
a gas supply module including a process gas line for supplying a process gas for the heat treatment to the internal chamber at a first pressure higher than that of the atmosphere and a protective gas line for supplying a protective gas to the external chamber at a second pressure set in relation to the first pressure; and
a purge module configured to purge the protective gas by injecting a purge gas into the external chamber,
wherein the purge module includes
a ring body surrounding the internal chamber, and
a discharge channel positioned in the ring body, and discharging the input purge gas to the internal chamber.

12. The apparatus of claim 11, wherein the discharge channel includes
a loop line extending in a circumferential direction of the ring body, and
a plurality of branch lines connected to the loop line and arranged to direct the internal chamber.

13. The apparatus of claim 11, further comprising a heating module disposed in the external chamber and configured to heat the process gas and the protective gas,
wherein the discharge channel discharges the purge gas into a space between the internal chamber and the heating module.

14. The apparatus of claim 11, wherein the gas supply module further includes a purge gas line connected to the protective gas line and supplying the purge gas to the discharge channel.

15. The apparatus of claim 11, further comprising a gas exhaust module configured to exhaust the process gas and the protective gas from the internal chamber and the external chamber,
wherein the gas exhaust module exhausts the protective gas to maintain the second pressure when the purge gas is injected.
